Europäisches Patentamt

European Patent Office

Office européen des brevets

(19)

(11) Veröffentlichungsnummer: **0 189 752 B1**

## (12) EUROPÄISCHE PATENTSCHRIFT

(45) Veröffentlichungstag der Patentschrift: **05.06.91**

(51) Int. Cl.⁵ **G03F 7/42**

(21) Anmeldenummer: **86100104.8**

(22) Anmeldetag: **07.01.86**

Die Akte enthält technische Angaben, die nach dem Eingang der Anmeldung eingereicht wurden und die nicht in dieser Patentschrift enthalten sind.

(54) **Verfahren zur Entfernung von Fotoresist- und Stripperresten von Halbleitersubstraten.**

(30) Priorität: **19.01.85 DE 3501675**

(43) Veröffentlichungstag der Anmeldung:
**06.08.86 Patentblatt 86/32**

(45) Bekanntmachung des Hinweises auf die
Patenterteilung:
**05.06.91 Patentblatt 91/23**

(84) Benannte Vertragsstaaten:
**BE CH DE FR GB IT LI**

(56) Entgegenhaltungen:
**EP-A- 0 120 528          GB-A- 1 573 208**
**GB-A- 2 068 405          US-A- 2 914 482**
**US-A- 3 663 445          US-A- 4 202 703**

**W.S. DEFOREST: "Photoresist materials and processes", 1975, McGraw-Hill Book Co., Seiten 129,161,247,249, New York, US.**

**PATENTS ABSTRACTS OF JAPAN, Band 8, Nr. 208 (P-302) [1645], 21. September 1984; & JP - A - 59 90 850 (TOSHIBA K.K.) 25-05-1984**

(73) Patentinhaber: **MERCK PATENT GESELL-SCHAFT MIT BESCHRÄNKTER HAFTUNG**
**Frankfurter Strasse 250 Postfach 4119**
**W-6100 Darmstadt(DE)**

(72) Erfinder: **Neisius, Karl-Heinz, Dr.**
**Kattreinstrasse 76**
**W-6100 Darmstadt(DE)**
Erfinder: **Litters, Alois**
**Ausserhalb 8**
**W-6840 Lampertheim Hofheim(DE)**

# EP 0 189 752 B1

## Beschreibung

Die Erfindung betrifft ein verbessertes Verfahren zur Entfernung von Fotoresistund Stripperresten von Halbleitersubstraten.

Die Herstellung von Halbleiterbauteilen und integrierten Schaltungen erfolgt heute praktisch ausschließlich unter Anwendung fotolithographischer Prozesse. Zur Strukturierung werden die Halbleitersubstrate mit Fotolacken - Positiv- oder Negativ-Fotoresists - beschichtet und durch bildmäßiges Belichten und anschließendes Entwickeln Fotoresistreliefstrukturen auf ihnen erzeugt. Diese dienen dann als Maske für die eigentlichen Strukturierungsprozesse wie Ätzen, Dotieren, Beschichten mit Metallen, anderen Halbleiter- oder auch Isolatormaterialien. Nach diesen Prozessen müssen die Fotoresistmasken wieder entfernt werden.

Hierzu dienen spezielle Ablösemittel, im einschlägigen Sprachgebrauch Stripper genannt. Diese sind üblicherweise Gemische von organischen Lösungsmitteln, die darüberhinaus oberflächenaktive Substanzen, im allgemeinen Gemische von Alkylbenzolsulfonsäuren, enthalten.

Zur Entfernung der Fotoresistbeschichtungen werden die Halbleitermaterialien - meist handelt es sich hierbei um Siliciumscheiben, sogenannte Wafer - in ein derartiges Stripperbad getaucht, das zur Steigerung seiner Effektivität üblicherweise auf Temperaturen zwischen 80 und 150 °C, meist um 100 °C, erhitzt ist. Hierbei wird nach mehr oder weniger kurzer Zeit der Fotolack abgelöst.

Nach dem Ablösen des Lackes ist es erforderlich, daß den Halbleitermaterialien noch anhaftende Reste von Stripper sowie eventuelle unvollständig enfernte Fotolackreste oder Abbauprodukte hiervon entfernt werden, um eine völlig saubere, den hohen Reinheitsanforderungen der Halbleitertechnik entsprechende Oberfläche zu erhalten. Dies kann etwa in einem oder mehreren Zwischenbädern, beispielsweise in organischen Lösungsmitteln wie Aceton, Alkoholen oder Xylol und anschließendem Nachspülen mit deionisiertem Wasser erfolgen.

Schon aus Gründen der Prozessvereinfachung und der Ersparnis aber auch aus Gründen des Schutzes am Arbeitsplatz und der Umwelt, sucht man nun den Zwischenbadschritt mit organischen Lösungsmitteln zu vermeiden.

Entsprechend hat sich durchgesetzt, die Halbleitersubstrate unmittelbar nach der Herausnahme aus dem Stripperbad direkt mit Wasser abzuspülen. Taucht man aber nach dem Strippvorgang einen mit Stripperresten behafteten Wafer nicht erst in organische Lösungsmittel, sondern direkt in ein nichtbewegtes Wasserbad, dann bildet sich durch ausfallende Alkylbenzolsulfonsäure ein Niederschlag. Dieser kann mit Wasser entfernt werden und dies um so schneller, je stärker man das Wasserbad bewegt. Günstiger ist das Abspülen unter fließendem Wasser wobei dieses möglichst unter leichtem Druck stehen sollte. Das Abspülen von Stripperresten mit Wasser unmittelbar nach dem Strippvorgang setzt allerdings voraus, daß der Fotolack beim Strippen vollkommen abgelöst wurde und der Wafer nach der Herausnahme aus dem Bad nur mit Stripperresten, nicht aber mit Fotolackresten behaftet ist. Erfahrungsgemäß ist dies beim Strippen von Negativ-Fotoresists im allgemeinen der Fall. Bei Negativ-Fotoresists, die überwiegend auf zyklisierten Kautschukmaterialien und lichtempfindlichen Bisazidoverbindungen basieren, ist somit ein Nachspülen mit Wasser nach dem Strippvorgang möglich.

Als schwieriger erweisen sich die Verhältnisse bei Positiv-Fotoresistmaterialien. Derartige Materialien basieren üblicherweise auf Formaldehyd-Phenol-Kondensaten vom Novolakharz-Typ und lichtempfindlichen Chinondiazidsulfonylderivaten. Die Fotolacke werden üblicherweise bei der Herstellung der Resistbeschichtung und nach der Fotostrukturierung zur Erhöhung der Haftung auf dem Substrat getempert. Die Temperaturen liegen hierbei zwischen 100 und 200 °C, meist zwischen 140 und 180 °C. Hierbei hängt die Verbesserung der Eigenschaften von der Höhe der Temperungstemperatur entscheidend ab. Auch bei nachfolgenden Plasmaätz- oder Ionenimplantationsprozessen werden die Beschichtungen höheren Temperaturen ausgesetzt. Derartige Positiv-Resists lassen sich, insbesondere wenn hochgetempert, durch die Stripperlösung nicht ohne weiteres vollständig vom Substrat ablösen. Beim Eintauchen frisch gestrippter Wafer in Wasser bilden nicht entfernte Lackreste zusammen mit ausfallenden Stripperbestandteilen und abgelösten Fotolackanteilen einen weitgehend unlöslichen Belag auf der Halbleiteroberfläche. Dieser Belag läßt sich auch mit fließendem Wasser und unter Druck nicht oder nur sehr schwer entfernen, so daß vollständig reine Oberflächen nur durch ein vorhergeschaltetes Zwischenbad mit organischen Lösungsmitteln zu erhalten sind.

Es ist daher wünschenswert, ein Verfahren und gegebenenfalls ein Mittel an der Hand zu haben, mit dem sich schnell, aber ohne Zuhilfenahme zusätzlicher organischer Zwischenbäder einwandfrei saubere Halbleiteroberflächen nach der Entfernung von Fotoresistbeschichtungen, insbesondere bei Positiv-Fotoresists, erhalten lassen.

Es wurde nun gefunden, daß sich dies überraschenderweise verwirklichen läßt, wenn man die Halbleitersubstrate nach dem Strippvorgang mit einem wäßrigen Nachspülmittel behandelt, das ein nichtionogenes Tensid und eine organische Base enthält.

Gegenstand der Erfindung ist somit ein Verfahren zur Entfernung von Halbleitersubstraten nach dem Strippvorgang verbliebener Fotoresist- und Stripperreste durch Behandlung mit einem Nachspülmittel, wobei man als Nachspülmittel eine wäßrige Lösung enthaltend, bezogen auf die Gesamtmenge, 0,1 - 10 Gew.% eines nichtiogenen Tensides der Gruppe der ethoxylierten Aklylphenole, der Fettsäureethoxylate, oder der Ethylenoxid/Propylenoxid-Kondensate und eine organische Base der Gruppe Ethanolamin, Diethanolamin oder Triethanolamin verwendet.

US-A-4,202,703 beschreibt ein Verfahren und ein Mittel zum Strippen von Fotoresists vom Halbleitersubstrat. Der verwendete Stripper enthält Tetramethylammoniumhydroxid in alkoholischer Lösung und gegebenenfalls ein Tensid. In jedem Fall ist ein Nachspülen mit 1,1,1-Trichlorethan erforderlich. Die Anwendung dieses polychlorierten Kohlenwasserstoffes ist heute äußerst bedenklich.

JP-A-59-90850 befaßt sich mit Stripperlösungen mit gleichen oder ähnlichen Bestandteilen.

Hinweise in Richtung auf Aufgabenstellung oder Lösung der vorliegenden Erfindung sind diesen Dokumenten nicht zu entnehmen.

Für das erfindungsgemäße Verfahren sind im Prinzip alle bekannten und gängigen nichtionogenen Tenside geeignet. Als besonders günstig haben sich nichtionogene Tenside der Gruppe der ethoxylierten Alkylphenole, der Fettsäureethoxylate, der Fettalkoholethoxylate sowie der Ethylenoxid Propylenoxid-Kondensate gezeigt.

Derartige Tenside sind großtechnische Produkte, die in beliebiger Zusammensetzung, als diskrete Einzelverbindungen, als Gemische und Fraktionverschnitte verfügbar sind.

Bevorzugt für den erfindungsgemäßen Verwendungszweck sind handelsübliche Ethoxylierungsprodukte von Alkylphenolen mit 6 bis 14 C-Atomen in der Alkylkette und Ethoxylierungsgraden von 2 bis 20, Fettsäure- bzw. Fettalkoholethoxylate mit gesättigten und ungesättigten Kohlenwasserstoffketten mit 8 bis 24 C-Atomen und Ethoxylierungsgraden von ebenfalls 2 bis 20 sowie Ethylenoxid Propylenoxid-Kondensate, die aus etwa 10 - 20 Monomereinheiten aufgebaut sind. Besonders bevorzugt sind ein ethoxyliertes Nonylphenol mit einem mittleren Ethoxylierungsgrad von 9 sowie Ethoxylate, die sich von Kokos-, Oleyl-, Stearyl- oder Talgfettsäure bzw. -fettalkohol ableiten und Ethoxylierungsgrade von 8 bis 12 aufweisen. Es können auch Produktverschnitte mit solchen Tensiden als Hauptkomponente oder Gemische verschiedener dieser Tenside verwendet werden.

Als zweite wesentliche Komponente enthält das im erfindungsgemäßen Verfahren eingesetzte Nachspülmittel eine organische Base. Prinzipiell sind alle einfachen organischen Basen geeignet, die ausreichend wasserlöslich sind und schnell mit Alkylbenzolsulfonsäuren gut wasserlösliche Salze bilden. Gut geeignet für diesen Zweck haben sich Basen aus der Gruppe Ethanolamin, Diethanolamin und Triethanolamin erwiesen, wobei Triethanolamin als besonders bevorzugt zu nennen ist.

Der Gehalt des im erfindungsgemäßen Verfahren eingesetzten Mittels an Tensid und organische Base sowie das mengenmäßige Verhältnis dieser beiden Komponenten zueinander ist weitgehend unkritisch. Als günstig für den erfindungsgemäßen Verwendungszweck haben sich Gehalte von 0,1 bis 10 Gew.% an Tensiden und 1 bis 10 Gew.% an Triethanolamin, bezogen auf die Gesamtmenge des einsatzbereiten Nachspülmittels, erwiesen. Besonders bevorzugt ist eine wäßrige Lösung, die 1 - 5 Gew.% an ethoxylierten Alkylphenolen und etwa 5 Gew.% an Triethanolamin enthält.

Die Herstellung des erfindungsgemäß verwendeten Nachspülmittels erfolgt in einfacher Weise durch Lösen bzw. Mischen der beiden Komponenten mit deionisiertem Wasser, gegebenenfalls unter leichter Erwärmung. Nach einer eventuell erforderlichen Feinfiltration zur Gewährleistung der in der Halbleiterelektronik erforderlichen Partikelfreiheit ist das Nachspülmittel gebrauchsfertig.

Nach dem Beschichten der Halbleiterscheiben mit einem Fotoresist, Belichten, Entwickeln und Strippen in üblicher Weise, werden diese direkt nach der Entnahme aus dem Stripperbad in ein Bad des erfindungsgemäßen Nachspülmittels getaucht, vorzugsweise unter leichter Bewegung. Normalerweise erfolgt der Nachspülvorgang bei Raumtemperatur. Das Nachspülmittel kann, falls zweckmäßig, auch leicht erwärmt sein, etwa auf Temperaturen um 50 °C.

Es zeigt sich hierbei, daß mit dem erfindungsgemäß eingesetzten Mittel im Falle von gestrippten Negativ-Fotoresistbeschichtungen der Nachspülvorgang deutlich kürzere Zeit in Anspruch nimmt, um einwandfrei saubere Waferoberflächen zu erhalten, als bei Nachspülung nur mit Wasser. Nachspülzeiten von 0,5 bis 1 Minute sind ausreichend gegenüber üblicherweise 1 bis 2 Minuten mit Wasser.

Besonders überraschend ist das Ergebnis im Falle gestrippter Positiv-Fotoresistbeschichtungen. Selbst bei Positiv-Resists, die bei Temperaturen bis 180 °C nachbehandelt wurden, lassen sich nach dem Strippen, das gerade bei hochgetempertem Material meist unvollständig abläuft, durch Nachspülen mit dem erfindungsgemäß verwendeten Mittel innerhalb 1 bis 5 Minuten einwandfrei saubere Waferoberflächen erhalten. Dies war nach den bisherigen Methoden in derart einfacher und problemloser Weise nicht möglich.

Nach der Herausnahme der Halbleitermaterialien aus dem Nachspülmittel wird noch kurz mit deionisiertem Wasser abgespült; nach dem vollständigen Trocknen der Halbleitersubstrate können diese nun sofort den weiteren üblichen Verarbeitungsprozessen zugeführt werden.

Beispiele

1. Ein Nachspülmittel wird bereitet aus
50 g ethoxyliertem Nonylphenol (mittlerer Ethoxylierungsgrad etwa 9)
50 g Triethanolamin und
900 ml deionisiertem Wasser.

2. Anwendung

An der Oberfläche thermisch oxydierte Silicium-Wafer werden in üblicher Weise mit handelsüblichem Negativ-Fotoresist oder Positiv-Fotoresist beschichtet, belichtet und entwickelt. Danach werden sie bei Temperaturen zwischen 140 und 200 °C einer Nachtemperung (Postbake) unterzogen. Anschließend erfolgt das Strippen in einem handelsüblichen Stripperbad, wobei die Behandlung bei unterschiedlichen Zeiten und Temperaturen oder mehrmals erfolgen kann. Nach der Herausnahme aus dem Stripperbad werden die Wafer mit dem Nachspülmittel nach Beispiel 1 oder zum Vergleich mit fließendem Wasser behandelt.

Die detaillierten Prozessbedingungen sowie die Ergebnisse sind in der nachfolgenden Tabelle 1 wiedergegeben.

Tabelle 1

| Foto-resist-Typ | Temperung (Postbake) Zeit/Temperatur | Strippen Zeit/Temperatur 1. Bad | 2. Bad | Nachspülen fließendes Wasser | Eintauchen in erfindungsgemäßes Mittel |
|---|---|---|---|---|---|
| | | | | Nachspülzeit | |
| | | | | 1 - 2' | 0,5 - 1' |
| Negativ | 30'/140 °C | 5'/100 °C | 5'/100 °C | + | + |
| | 30'/170 °C | 5'/100 °C | 5'/100 °C | + | + |
| | | | | > 5' | 1 - 5' |
| Positiv | 30'/140 °C | 5'/100 °C | 5'/100 °C | - | + |
| | 30'/160 °C | 5'/130 °C | 5'/130 °C | - | + |
| | 30'/180 °C | 10'/130 °C | 5'/130 °C | - | + |
| | 30'/200 °C | 50'/130 °C | ./. | - | - |

+: gutes Ergebnis; einwandfrei saubere Oberfläche

-: unbrauchbares Ergebnis; Verunreinigungen auf den Oberflächen

Es zeigt sich, daß im Falle von Negativ-Resists durch Nachspülen unter fließendem deionisiertem Wasser,

EP 0 189 752 B1

deutlich schneller jedoch mit dem erfindungsgemäß eingesetzten Mittel, saubere Waferoberflächen erhalten lassen.

Im Falle von Positiv-Resists, insbesondere wenn diese zwischen 140 und 180 ° getempert wurden, werden einwandfrei saubere Wafer nur dann erhalten, wenn diese sofort nach dem Strippen mit dem erfindungsgemäß eingesetzten Nachspülmittel behandelt werden.

## Ansprüche

1. Verfahren zur Entfernung von auf Halbleitersubstraten nach dem Strippvorgang verbliebener Fotoresist- und Stripperreste durch Behandlung mit einem Nachspülmittel, dadurch gekennzeichnet, daß man als Nachspülmittel eine wäßrige Lösung enthaltend, bezogen auf die Gesamtmenge, 0,1 - 10 Gew.% eines nichtionogenen Tensides der Gruppe der ethoxylierten Alkylphenole, der Fettsäureethoxylate, oder der Ethylenoxid/Propylenoxid-Kondensate und organische Base der Gruppe Ethanolamin, Diethanolamin oder Triethanolamin verwendet.

2. Verfahren nach Anspruch 1, dadurch gekennzeichnet, daß man als Nachspülmittel eine wäßrige Lösung enthaltend, bezogen auf die Gesamtmenge, 1 - 5 Gew.% ethoxylierte Alkylphenole und 1 - 10 Gew%. vorzugsweise etwa 5 Gew.% Triethanolamin verwendet.

## Claims

1. Method for removing remnant photoresist and stripper residues from semiconductor substrates after the stripping operation by treatment with a post-rinsing agent, characterised in that an aqueous solution containing, referred to the total quantity, 0.1 - 10% by weight of a nonionogenic surfactant of the group comprising the ethoxylated alkylphenols, the fatty acid ethoxylates and the ethylene oxide propylene oxide condensates and an organic base of the group comprising ethanolamine, diethanolamine or triethanolamine is used as post-rinsing agent.

2. Method according to Claim 1, characterised in that an aqueous solution containing, referred to the total quantity, 1 - 5% by weight of ethoxylated alkylphenols and 1 - 10% by weight, preferably about 5% by weight, of triethanolamine is used as post-rinsing agent.

## Revendications

1. Procédé pour débarrasser des supports de semiconducteurs des résidus de photoréserves et de solvants subsistant après l'opération de lavage ("strippage") par traitement à l'aide d'un produit de rinçage, caractérisé en ce qu'on utilise en tant que produit de rinçage une solution aqueuse contenant de 0,1 à 10 % de son poids total d'un agent tensio-actif non-ionique du groupe des alkylphénols éthoxylés, des acides gras éthoxylés ou des condensats oxyde d'éthylène oxyde de propylène et une base organique du groupe de l'éthanolamine, de la diéthanolamine et de la triéthanolamine

2. Procédé selon la revendication 1, caractérisé en ce que l'on utilise en tant que produit de rinçage une solution aqueuse contenant de 1 à 5 % de son poids total d'alkylphénols éthoxylés et de 1 à 10 % en poids, de préférence environ 5 % en poids, de triéthanolamine.